Europäisches Patentamt

(19) European Patent Office

Office européen des brevets

(11) EP 0 859 461 A1

(12) EUROPEAN PATENT APPLICATION

(43) Date of publication:
19.08.1998 Bulletin 1998/34

(51) Int. Cl.$^6$: H03D 7/14

(21) Application number: 97102593.7

(22) Date of filing: 18.02.1997

(84) Designated Contracting States:
DE GB

(71) Applicant: NEC CORPORATION
Tokyo (JP)

(72) Inventor: Kagawa, Shigeru
Minato-ku, Tokyo (JP)

(74) Representative:
Baronetzky, Klaus, Dipl.-Ing. et al
Patentanwälte
Dipl.-Ing. R. Splanemann, Dr. B. Reitzner, Dipl.-Ing. K. Baronetzky
Tal 13
80331 München (DE)

(54) Mixer circuit with wide dynamic range

(57) A mixer circuit includes a first unbalance type differential circuit (1,3) having the first unbalance current ratio (n), wherein the first unbalance type differential circuit is connected to the first output terminals (41,42) and the first input terminals (14,15), an input signal being inputted between the first input terminals. The second unbalance type differential circuit (2,4) has the second unbalance current ratio (n) inverse to the first unbalance current ratio of the first unbalance type differential circuit (1,3). The second unbalance type differential circuit (2,4) is connected to the first output terminals (41,42) and the first input terminals (14,15) in parallel to the first unbalance type differential circuit. The first balance type differential circuit (5,6) is connected to one of the first output terminals (41), and connected to the second input terminals (16,17) such that a local signal is supplied to the first balance type differential circuit (5,6) in the first connection manner. The second balance type differential circuit (7,8) is connected to the other of the first output terminals (42) and connected to the second input terminals (16,17) such thet the local signal is supplied to the second balance type differential circuit in the second connection manner inverse to the first connection manner. A converting section (10) converts at least one of outputs from the first and second balance type differential circuits (5,6,7,8) on the second output terminals from a current form into a voltage form. An output section (9,13) buffers the at least one output converted by the converting section (10).

Fig. 3 PRIOR ART

## Description

## Background of the Invention

### 1. Field of the Invention

The present invention relates to a mixer circuit, and more particularly to a mixer circuit which is used for a communication equipment.

### 2. Description of Related Art

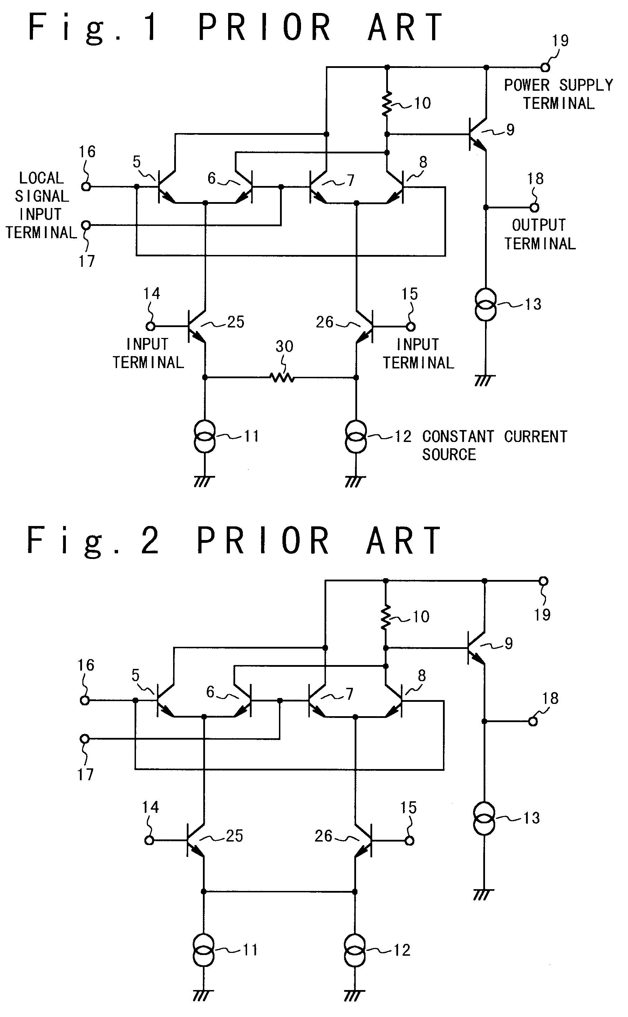

A mixer circuit composed of a dual differential circuit is conventionally known. Fig. 1 is a circuit diagram illustrating the first conventional example of the mixer circuit composed of a dual differential circuit which is composed of transistors 5 to 8, 25 and 26. Referring to Fig. 1, in the first conventional example of the mixer circuit, an input signal is inputted between input terminals 14 and 15 and are mixed with a local signal which is inputted between local signal input terminals 16 and 17. The mixed signal is outputted to an output terminal 18 as an output signal. In this case, assuming that the frequencies of input signal, local signal and output signal are $f_I$, $f_L$ and $f_O$, respectively, the following relation is satisfied:

$$f_O = |f_I \pm f_L|$$

That is, frequency conversion is performed.

Also, in the first conventional example of the mixer circuit, a resistor 30 is inserted between the emitters of the transistors 25 and 26 for making wide the dynamic range of a differential circuit composed of the transistors 25 and 26. However, the thermal noise generated from the resistor 30 is one of causes that the noise performance is degraded.

Fig. 2 is a circuit diagram illustrating the second conventional example of the mixer circuit. Referring to Fig. 2, the difference point in structure between the second conventional example shown in Fig. 2 and the first conventional example shown in Fig. 1 is in that the resistor 30 is removed. By removing the resistor 30, the dynamic range of the differential circuit of an input section which is composed of the transistors 25 and 26 is made narrow. However, because there is not the thermal noise which is generated from the resistor 30, the noise performance becomes better than the mixer circuit of the first convention example shown in Fig. 1.

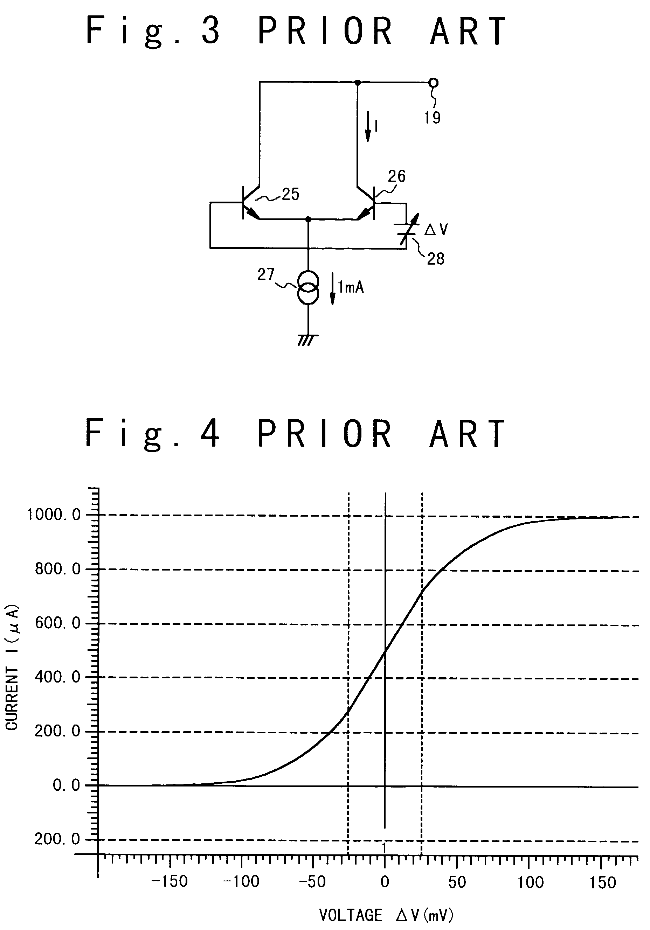

Fig. 3 is a circuit diagram of the differential circuit extracted from the second conventional example of the mixer circuit shown in Fig. 2 and the differential circuit of the input section for the input signal is composed of the transistors 25 and 26. Fig. 4 is a characteristic diagram illustrating the simulation result of the differential circuit shown in Fig. 3 by a simulation apparatus SPICE. As seen from the characteristic diagram of Fig. 4, the dynamic range, i.e., a linear portion of a characteristic curve of the second conventional example of the mixer circuit is $\Delta V = \pm 26$ mV.

In this manner, in the conventional mixer circuits, there is a problem in that improvement of the noise performance and the extension of the dynamic range can not be established at the same time in the differential circuit. That is, in the first conventional example of the mixer circuit shown in Fig. 1, the dynamic range of the differential circuit in the input section is large but the noise performance is worse because of the thermal noise of the resistor 30. On the other hand, in the second conventional example of the mixer circuit shown in Fig. 2, because there is not the resistor 30 in the differential circuit, the noise performance is good but the dynamic range of the differential circuit is narrow.

## Summary of the Invention

The present invention is made in the light of the above-mentioned circumstances. An object of the present invention is to provide a mixer circuit in which noise performance can be improved and an input dynamic range can be made wide.

In order to achieve an aspect of the present invention, a mixer circuit, includes a first unbalance type differential circuit having a first unbalance current ratio, wherein the first unbalance type differential circuit is connected to first output terminals and first input terminals, an input signal being inputted between the first input terminals; a second unbalance type differential circuit having a second unbalance current ratio inverse to the first unbalance current ratio of the first unbalance type differential circuit, wherein the second unbalance type differential circuit is connected to the first output terminals and the first input terminals in parallel to the first unbalance type differential circuit; a first balance type differential circuit connected to one of the first output terminals, connected to one of second output terminals, and connected to second input terminals such that a local signal is supplied to the first balance type differential circuit in a first connection manner; a second balance type differential circuit connected to the other of the first output terminals, connected to the other of the second output terminals, and connected to the second input terminals such that the local signal is supplied to the second balance type differential circuit in a second connection manner inverse to the first connection manner; a converting section for converting at least one of outputs from the first and second balance type differential circuits on the second output terminals from a current form into a voltage form; and an output section for buffering the at least one output converted by the converting section.

In this case, it is preferable that the first unbalance current ratio is in a range of 4 to 8, and the most preferable that the unbalance current ratio is 6.

The first unbalance type differential circuit is composed of first and second transistors connected to the first input terminals and the first output terminals, and having emitters connected in common, respectively. The second unbalance type differential circuit is composed of third and fourth transistors connected to the first input terminals and the first output terminals, and having emitters connected in common, respectively. The first and second transistors flow current in accordance with the first unbalance current ratio in the first unbalance type differential circuit. The third and fourth transistors flow current in accordance the second unbalance current ratio in the second unbalance type differential circuit. In this case, the first transistor may have an emitter area wider than the second transistor in proportional to the first unbalance current ratio and the fourth transistor may have an emitter area wider than the third transistor in proportional to the second unbalance current ratio. Alternatively, n transistors each having the same emitter area as the second transistor and connected in parallel may be used in place of the first transistor and n transistors each having the same emitter area as the third transistor and connected in parallel may be used in place of the fourth transistor.

When the converting section is composed of a load circuit connected to one of the first output terminals of the first and second balance type differential circuits, the load circuit may be composed of a resistor, or the load circuit may be a resonance circuit.

In order to achieve another aspect of the present invention, a mixer circuit includes a first transistor whose base is connected to one of first input terminals for a first input signal, a second transistor whose base is connected to the one of the first input terminals and whose collector is connected to a first common node together with a collector of the first transistor, a third transistor whose base is connected to the other of the first input terminals, and whose emitter is connected to a first current source together with an emitter of the first transistor, wherein the first transistor can flow current n times (n is a positive value in a range of 4 to 8) more than the third transistor such that the first and third transistors form a first unbalance type differential circuit, a fourth transistor whose base is connected to the other of the first input terminals, whose collector is connected to a second common node together with a collector of the third transistor, and whose emitter is connected to a second current source together with an emitter of the second transistor, wherein the fourth transistor can flow current n times more than the second transistor such that the second and fourth transistors form a second unbalance type differential circuit, a fifth transistor whose base is connected to one of local signal input terminals for a local signal, a sixth transistor whose base is connected to the other of the local signal input terminals, and whose emitter is connected to the first common node together with an emitter of the fifth transistor, a seventh transistor whose base is connected to the other of the local signal input terminals, and whose collector is connected to a third common node together with a collector of the fifth transistor, an eighth transistor whose base is connected to the one of the local signal input terminals, whose emitter is connected to the second common node together with an emitter of the seventh transistor, and whose collector is connected to a fourth common node together with a collector of the sixth transistor, a converting section disposed between a power supply terminal and the third and fourth common nodes, for converting at least one of outputs on the third and fourth common nodes from a current form into a voltage form, and an output section for buffering the at least one output converted by the converting section.

In order to achieve still another aspect of the present invention, a mixer circuit using a dual differential circuit, comprising an input section includes a first transistor whose base is connected to a first input terminal for a first input signal, a second transistor whose base is connected to the first input terminal and whose collector is connected to a first common node together with a collector of the first transistor, a third transistor whose base is connected to a second input terminal for a second input signal, and whose emitter is connected to a first current source together with an emitter of the first transistor, wherein the first transistor can flow current n times (n is a positive value in a range of 4 to 8) more than the third transistor such that the first and third transistors form a first unbalance type differential circuit, and a fourth transistor whose base is connected to the second input terminal, whose collector is connected to a second common node together with a collector of the third transistor, and whose emitter is connected to a second current source together with an emitter of the second transistor, wherein the fourth transistor can flow current n times more than the second transistor such that the second and fourth transistors form a second unbalance type differential circuit.

**Brief Description of the Drawings**

Fig. 1 is a circuit diagram illustrating the first conventional example of a mixer circuit;
Fig. 2 is a circuit diagram illustrating the second conventional example of the mixer circuit;
Fig. 3 is a circuit diagram illustrating a differential circuit of an input section which is extracted from the second conventional example of the mixer circuit shown in Fig. 2;
Fig. 4 is a characteristic diagram illustrating the simulation result of the differential circuit shown in Fig. 3 by a simulation apparatus SPICE;
Fig. 5 is a circuit diagram illustrating the mixer circuit according to the first embodiment of the present invention;
Fig. 6 is a circuit diagram illustrating a dual differential circuit of an input section which is extracted from the mixer circuit shown in Fig. 5;
Fig. 7 is a characteristic diagram illustrating the simulation result of the dual differential circuit shown in Fig. 6 by the simulation apparatus SPICE;
Fig. 8 is a circuit diagram illustrating the mixer circuit according to the second embodiment of the present invention;
Fig. 9 is a circuit diagram illustrating the mixer circuit according to the third embodiment of the present invention; and
Fig. 10 is a circuit diagram illustrating the mixer circuit according to the fourth embodiment of the present invention.

## Description of the Preferred Embodiments

Next, the mixer circuit of the present invention will be described below in detail with reference to the accompanying drawings.

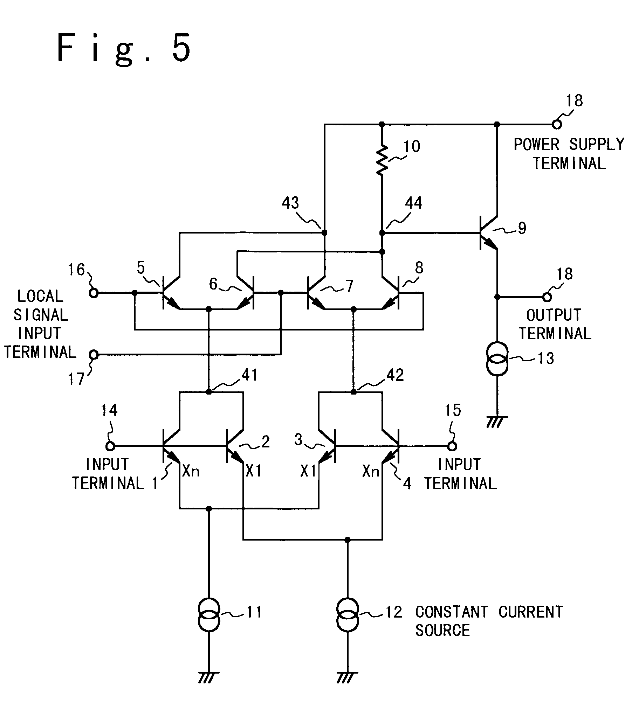

Fig. 5 is a circuit diagram of the mixer circuit according to the first embodiment of the present invention. Referring to Fig. 5, the mixer circuit includes an input section for an input signal composed of the first unbalance type differential circuit and the second unbalanced differential circuit. The first unbalance type differential circuit is composed of NPN transistors 1 and 3 whose emitters are connected in common to a constant current source 11. An input signal is supplied to the bases of the transistors 1 and 3. The emitter area of the transistor 1 is wide n times (n is a positive number), compared to that of the transistor 3. As a result, the transistor 1 can flow collector current n times more than the transistor 3. The second unbalance type differential circuit is composed of NPN transistors 2 and 4 whose emitters are connected in common to a constant current source 12. The input signal is also supplied to the bases of the transistors 2 and 4. The emitter area of the transistor 4 is wide n times, compared to that of the transistor 2. As a result, the transistor 4 can flow more collector current n times than the transistor 2. The collectors of the transistors 1 and 2 are connected to a common node 41 in common and the collectors of the transistors 3 and 4 are connected to a common node 42 in common. The constant current source 11 flows current of the same magnitude as the constant current source 12.

Also, the mixer circuit of the first embodiment is composed of the first and second local balance type differential circuits. The first local balance type differential circuit is composed of NPN transistors 5 and 6 and the second local balance type differential circuit is composed of NPN transistors 7 and 8. The bases of the transistors 5 and 8 are connected in common to a local signal input terminal 16 and the bases of the transistors 6 and 7 are connected in common to a local signal input terminal 17. That is, the local signal is supplied to the second balance type differential circuit in a connection manner inverse to that in the first balance type differential circuit. The emitters of the transistors 5 and 6 are connected in common to the common node 41 to which the collectors of the transistors 1 and 2 are connected in common. Also, the emitters of the transistors 7 and 8 are connected to the common node 42 to which the collectors of the transistors 3 and 4 are connected in common. The collectors of the transistors 5 and 7 are connected in common to a power supply terminal 19 via a common node 43. Also, the collectors of the transistors 6 and 8 are connected to a common node 44 in common. A resistor 10 is provided between the power supply terminal 19 and the common node 44.

The common node 44 between the resistor 10 and the collector of the transistor 8 is connected to the base of an NPN transistor 9 of an output section. The collector of the transistor 9 is connected to the power supply terminal 19. The output section is further composed of a constant current source 13 and the emitter of the transistor 9 is connected to the constant current source 13. An output of the mixer circuit in the first embodiment is taken out from an output terminal 18 between the emitter of the transistor 9 and the constant current source 13. The current value of the constant current source 13 is determined based on impedance conversion.

As described above, the mixer circuit in the first embodiment is different from the conventional examples at the following point. That is, the balance type differential circuit composed of the transistors 25 and 26 in the conventional examples is replaced by parallel connection of the unbalance type differential circuit composed of the transistors 1 and 3 and the unbalance type differential circuit composed of the transistors 2 and 4.

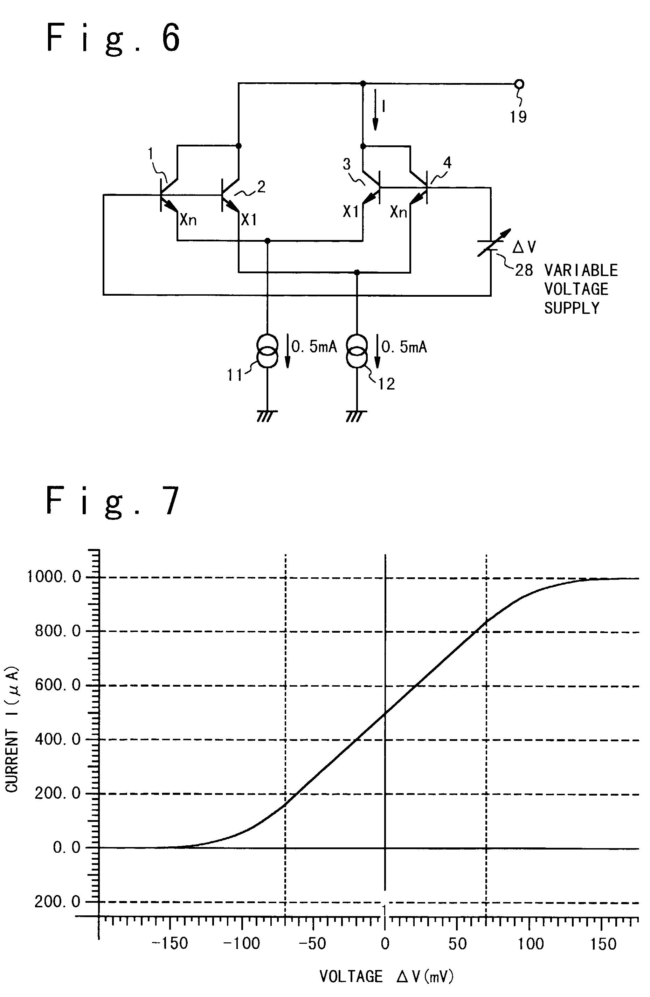

Next, the operation of the input section of the first embodiment will be described with reference to Figs. 6 and 7. Fig. 6 is a circuit diagram illustrating the input section which is extracted from the mixer circuit shown in Fig. 5. Fig. 7 is a characteristic diagram illustrating the simulation result of the input section shown in Fig. 6 by the simulation apparatus SPICE.

First, the dynamic range of the input section shown in Fig. 6 will be described. As shown in Fig. 6, the input section of the first embodiment is composed of the unbalance type differential circuit composed of the transistors 1 and 3 and the unbalance type differential circuit composed of the transistors 2 and 4. A variable voltage supply 28 is connected between the bases of the transistors 1 and 2 and the bases of the transistors 3 and 4. Both of the constant current source 11 and 12 flow the current of 0.5 mA. At that time, the current I and the voltage $\Delta V$ are simulated by the simulation apparatus SPICE. The dynamic range of the input section is simulated while n is changed, where n is an emitter area factor.

As the result of the simulation, the dynamic range wider than the conventional examples could be obtained when n was in a range of 4 to 8. The best result was obtained when n is 6. Fig. 7 is a characteristic diagram illustrating the simulation result of the dynamic range of the input section by the simulation apparatus SPICE when n is 6. As seen from the characteristic diagram, the dynamic range when n = 6, i.e., the linear portion of the characteristic curve is $\Delta V = \pm 70$ mV. The

value of n may be changed in accordance with the required dynamic range. That is, these unbalance type differential circuits complement the dynamic range with each other to make the total dynamic range wide.

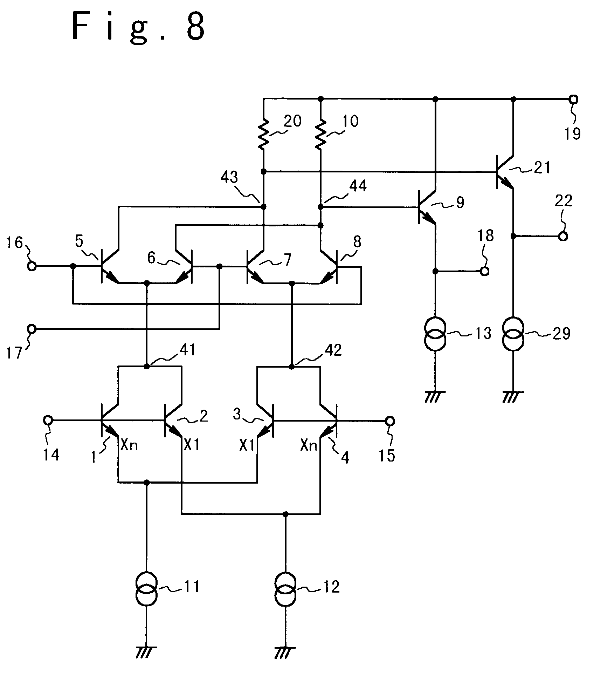

Next, the mixer circuit according to the second embodiment of the present invention will be described below. Fig. 8 is the circuit diagram illustrating the mixer circuit according to the second embodiment of the present invention. The mixer circuit of the second embodiment has substantially the same circuit structure as that of the first embodiment. The mixer circuit of the second embodiment is different from that of the first embodiment in the point that a resistor 20 having the same resistance as the resistor 10 is inserted between the power supply terminal 19 and the common node 43 between the collectors of the transistors 5 and 7 and the output is taken out in the differential form. For this purpose, the output section is further composed of a constant current source 29 and a transistor 21 whose collector is connected to the power supply terminal 19, whose base is connected to the common node 43 between the resistor 20 and the collectors of the transistors 5 and 7, and whose emitter is connected to the constant current source 29 which supplies the same current as the constant current source 13, in addition to the transistor 9 and the constant current source 13. The output is supplied in a differential manner by the output terminal 18 and the output terminal 22 between the emitter of the transistor 21 and the constant current source 29. In this case, it has the advantage that the gain can be obtained twice.

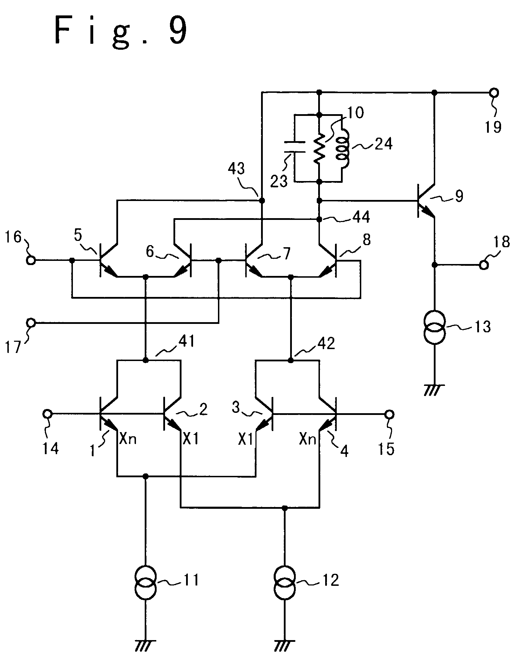

Next, the mixer circuit according to the third embodiment of the present invention will be described below. Fig. 9 is the circuit diagram illustrating the mixer circuit according to the third embodiment of the present invention. As seen from Fig. 9, the mixer circuit of the third embodiment has substantially the same circuit structure as that of the first embodiment. The mixer circuit of the third embodiment is different from that of the first embodiment in the point that a resistor 10 as load is replaced by a parallel resonance circuit which is composed of a capacitor 23, the resistor 10, and an inductor 24. In the third embodiment, because band limitation can be performed to the output signal in the band by the parallel resonance circuit, there is the advantage that noise and spurious output can be suppressed.

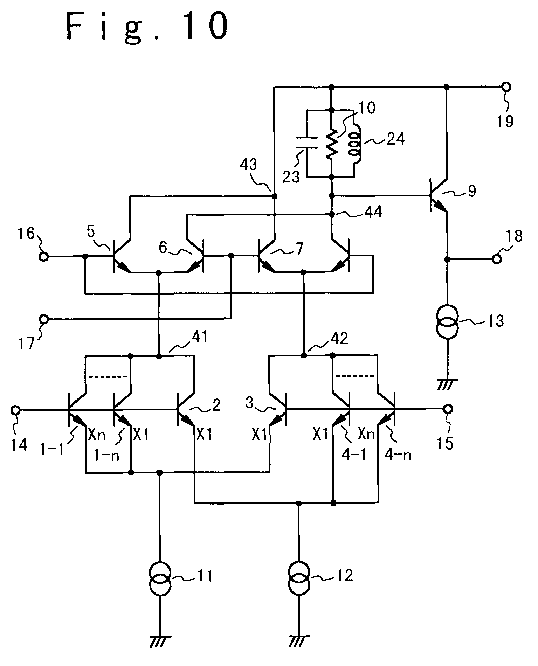

Next, the mixer circuit according to the fourth embodiment of the present invention will be described below. Fig. 10 is the circuit diagram illustrating the mixer circuit according to the fourth embodiment of the present invention. As seen from Fig. 10, the mixer circuit of the fourth embodiment has substantially the same circuit structure as that of the first embodiment. The mixer circuit of the fourth embodiment is different from that of the first embodiment in the point that n NPN transistors 1-1, ..., 1-n each of which has the same characteristics as the transistor 3 is used in place of the transistor 1 and n NPN transistors 4-1, ..., 4-n each of which has the same characteristics as the transistor 2 is used in place of the transistor 4.

In the above embodiments, the NPN transistors are used. However, N-channel MOS transistors could be applied in place of the NPN transistors. If the circuit diagram is rewritten, PNP transistors or P-channel MOS transistors could be also applied.

As described above, according to the present invention, because the unbalance type differential circuits are connected in parallel for the input section of the input signal in the dual differential circuits instead of the balance type differential circuit, there is achieved the effect that the noise performance is good and moreover that the dynamic range of the differential circuit in the input section is wide.

## Claims

1.  A mixer circuit using a dual differential circuit, comprising:

    a first unbalance type differential circuit (1, 3, 11) composed of a first transistor (1) and a second transistor (3), which have an unbalance current ratio of n : 1 (n is a positive value in a range of 4 to 8);
    a second unbalance type differential circuit (2, 4, 12) composed of a third transistor (2) and a fourth transistor (4) which has an unbalance current ratio of 1 : n, and
    wherein said first and second unbalance type differential circuits are connected in parallel such that collectors of said first and third transistors (1, 2) are connected to a first common node (41), collectors of said second and fourth transistors (3, 4) are connected to a second common node (42), bases of said first and third transistors (1, 2) are connected to a first input terminal (14), and bases of said second and fourth transistors (3, 4) are connected to a second input terminals (15).

2.  A mixer circuit according to claim 1, further comprising:

    first and second balance type differential circuits (5, 6, 7, 8) respectively connected to said first and second common nodes (41, 42), and wherein a local signal is supplied between first and second local signal input terminals (16, 17) of said first balance type differential circuit (5, 6) in a first connection manner and is supplied between said first and second local signal input terminals (16, 17) of said second balance type differential circuit (7, 8) in a second connection manner inverse to the first connection manner, and wherein said first and second balance type differential circuits have third and fourth common nodes (43, 44);

a converting section (10) for converting at least one of outputs from said first and second balance type differential circuits (5, 6, 7, 8) on said third and fourth output nodes (43, 44) from a current form into a voltage form; and

an output section (9, 13) for buffering said at least one output converted by said converting section.

3.  A mixer circuit according to claim 1 or 2, wherein said first unbalance type differential circuit includes:

said first transistor (1) whose base is connected to said first input terminal (14) for a first input signal; and

said second transistor (3) whose base is connected to said second input terminal (15) for a second input signal, and whose emitter is connected to a first current source (11) together with an emitter of the first transistor (1), wherein said first transistor (1) can flow current n times more than said second transistor, and

wherein said second unbalance type differential circuit includes:

said third transistor (2) whose base is connected to the first input terminal (14) and whose collector is connected to said first common node (41) together with a collector of said first transistor (1); and

a fourth transistor (4) whose base is connected to the second input terminal (15), whose collector is connected to said second common node (42) together with a collector of said second transistor (3), and whose emitter is connected to a second current source (12) together with an emitter of said third transistor (2), wherein said fourth transistor (4) can flow current n times more than said third transistor (2).

4.  A mixer circuit according to claim 2, wherein said first balance type differential circuit (5, 6) includes:

a fifth transistor (5) whose base is connected to said first local signal input terminal (16); and

a sixth transistor whose base is connected to said second local signal input terminal (17), and whose emitter is connected to said first common node (41) together with an emitter of said fifth transistor (5), and

wherein said second balance type differential circuit (7, 8) includes:

a seventh transistor (7) whose base is connected to the second local signal input terminal (17), and whose collector is connected to said third common node (43) together with a collector of said fifth transistor (5); and

an eighth transistor (8) whose base is connected to the first local signal input terminal (16), whose emitter is connected to said second common node (42) together with an emitter of said seventh transistor (7), and whose collector is connected to said fourth common node (44) together with a collector of said sixth transistor (6).

5.  A mixer circuit according to claim 3 or 4, wherein said first transistor (1) has an emitter area wider than said second transistor (3) and said fourth transistor (4) has an emitter area wider than said third transistor (2).

6.  A mixer circuit according to claim 3 or 4, wherein n transistors (1-1 to 1-n) each of which is the same as said second transistor (3) and which are connected in parallel are used in place of said first transistor (1), and wherein n transistors (4-1 to 4-n) each of which is the same as said third transistor (2) and which are connected in parallel are used in place of said fourth transistor (4).

7.  A mixer circuit according to any one of claims 2 to 6, wherein said converting section is composed of a load circuit connected between a power supply terminal (19) and one of said third and fourth common nodes (43, 44).

8.  A mixer circuit according to claim 7, wherein said load circuit is composed of a resistor (10).

9.  A mixer circuit according to claim 7, wherein said load circuit is a resonance circuit (10, 23, 24).

10. A mixer circuit according to claim 1, wherein said converting section is composed of two load circuits connected between a power supply terminal (19) and said third and fourth common nodes (43, 44).

11. A mixer circuit according to claim 10, wherein each of said load circuits is composed of a resistor (10, 20).

12. A mixer circuit according to claim 10, wherein each of said load circuits is a resonance circuit (10, 23, 24).

13. A mixer circuit according to claim 10, wherein said output section outputs an mixer circuit output in a differential form.

14. A mixer circuit according to any one of claims 1 to 13, wherein said unbalance current ratio is 6.

# Fig. 1 PRIOR ART

# Fig. 2 PRIOR ART

7

# Fig. 3 PRIOR ART

# Fig. 4 PRIOR ART

# Fig. 5

# Fig. 6

# Fig. 7

# Fig. 8

# Fig. 9

# Fig. 10

EP 0 859 461 A1

| European Patent Office | EUROPEAN SEARCH REPORT | Application Number EP 97 10 2593 |
|---|---|---|

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP 0 501 827 A (TOKYO SHIBAURA ELECTRIC CO) 2 September 1992<br>* column 6, line 30 - column 8, line 14; figures 1,4 *<br>* column 9, line 23 - line 52 * | 1-11,13 | H03D7/14 |
| X | GB 2 284 116 A (NIPPON ELECTRIC CO) 24 May 1995 | 1-3,5 | |
| A | * page 47, line 27 - page 48, line 2; figures 23,24 * | 4 | |
| A | GB 2 064 253 A (PHILIPS NV) 10 June 1981<br>* page 2, line 12 - line 13; figure 1 * | 12 | |
| A | GB 2 260 870 A (NIPPON ELECTRIC CO) 28 April 1993<br>* page 13, line 13; figure 3 * | 14 | |

TECHNICAL FIELDS SEARCHED (Int.Cl.6)

H03D

The present search report has been drawn up for all claims

| Place of search | Date of completion of the search | Examiner |
|---|---|---|
| THE HAGUE | 2 July 1997 | Peeters, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

14